# EUROPEAN PATENT SPECIFICATION

(11) **EP 1 798 196 B1**
(45) Date of publication and mention of the grant of the patent: **09.08.2017**
(21) Application number: 05257719.4
(22) Date of filing: 15.12.2005
(51) Int. Cl.: B81C 1/00

(54) **Multi-layer device with reduced UV radiations during encapsulation**
Mehrlagiges Bauelement mit Reduzierung der UV-Stahlung während der Verkapselung
Dispositif multi-couche avec reduction des radiations UV pendant l'encapsulation

(43) Date of publication of application: 20.06.2007
(73) Proprietor: Infineon Technologies AG, 85579 Neubiberg (DE)
(72) Inventor: Westgaard, Trond, Horten N-3192 (NO)
(74) Representative: Zimmermann, Tankred Klaus

(56) References cited:
- EP-A2- 0 786 645
- US-B1- 6 465 854

## Description

The present invention relates to a multi-layer device with gas-filled cavity.

There are currently many systems such as micro electromechanical systems (MEMS), which require silicon and glass to be bonded together in such a way that a sealed cavity is formed therebetween. The silicon and glass layers are generally bonded by means of anodic bonding which is performed at elevated temperatures (in the region of 650K) and high voltages (500 to 1000V).

In some applications it is beneficial to fill the sealed cavity in such devices with a gas. In this case, due to the electric field present during the bonding process, any available free electrons may be accelerated to cause ionisation of the gas. The applicants have appreciated that this has the problem that the ionised gas emits ultraviolet (UV) radiation which may change surface properties inside the cavity or negatively influence the stability of electronic components inside the cavity.

One way to try and minimise this problem is to reduce the bonding voltage to reduce the UV emission. However this does not eliminate UV emission completely and if the voltage is reduced too much the bonding process becomes unreliable.

US-A-6465854 discloses a micromechanical component.

EP 0 786 645 A2 relates to an angular rate sensor and acceleration sensor and to a fabrication process therefore. After the silicon process and glass process, finally by the assembling process, the silicon substrate and glass are bonded anodically and the vibrator is completed. First, at step (a), the upper glass and silicon substrate are bonded anodically. At next step (b), the extra supporting beam is cut off. At step (c), the silicon substrate bonded to the upper glass and the lower glass are bonded anodically Finally, wiring is connected at step (d).

The present invention addresses the above problem. According to the present invention there is provided a multi-layer device as defined in claim 1. According to the present invention there is further provided a method for manufacturing a multi-layer device as defined in claim 6. An example of the present invention will now be described with reference to the accompanying drawings, in which:
Figure 1 shows a cross-sectional view of an example multi-layer device according to the present invention;
Figure 2 shows a partial cross-sectional view of an alternative example multi-layer device according to the present invention;
Figure 3 is a diagram of an example electrode structure according to the example of the present invention shown in figure 1;

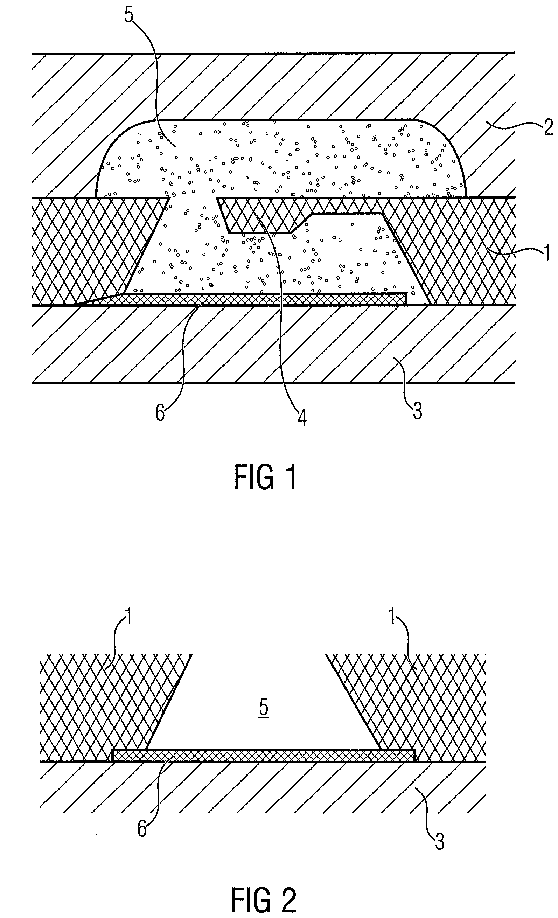

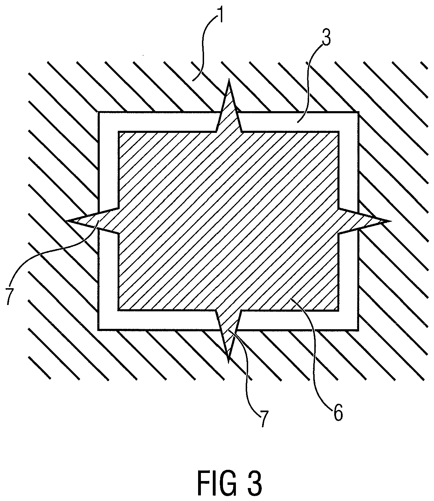

Figure 3 is a diagram of an example electrode structure according to the example according to the present invention shown in figure 2.

Referring to figure 1, a multi-layer device comprises a silicon layer 1 sandwiched between a first 2 and a second 3 glass sealing layer. The silicon layer 1 has a micro-mechanical component 4 formed thereon and the layers 1, 2, 3 are arranged such that a cavity 5 is formed around the active micro-mechanical component 4. This cavity 5 is filled with gas.

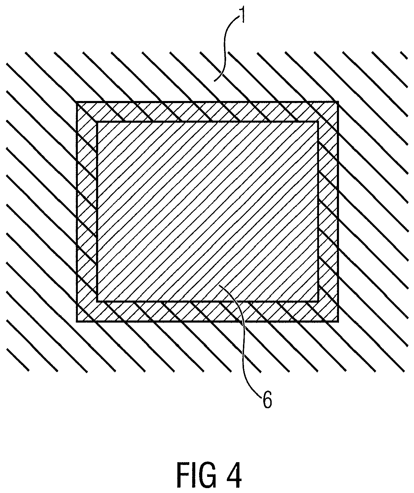

Referring to figures 1 to 4, an electrode 6 is formed on top of the second sealing layer 3. This electrode 6 is at a distance approaching the wafer thickness (typically 100 µm to 1000 µm) from the micro-mechanical component, which distinguishes it from electrodes for capacitive read-out or for electro-static actuation that would be at a distance of 10 µm or less. The electrode 6 may cover the entire exposed glass area and extend into the contact area between the silicon layer 1 and the second sealing layer 3. An example of this geometry is shown in figure 2 and figure 4.

Alternatively, the electrode area 6 may be reduced to the area where the active structure 4 is located, with the electrode extending outside this area with a distance approximately equal to the wafer thickness or longer. An example of this geometry is shown in figure 1 and figure 3. With this electrode design contact structures 7 bring the electrode pattern 6 into contact with the silicon layer 1 surrounding the cavity 5. This design interferes less with the bonding area, which is beneficial as most designs will try to minimize the total area of the device while maintaining sufficient bonding areas.

With both types of electrode designs the electrode potential is fixed at the silicon potential during anodic bonding. There is therefore low electric field strength between metallized areas 6 of the surface of the second sealing layer 3 and the silicon layer 1. As there is no UV emission in the first bonding step when no gas is present and low UV emission from these volumes of weak field during the second bonding step, the exposure to UV radiation is strongly reduced.

## Claims

1. A multi-layer device comprising:
a first layer (1) with a micro-mechanical component (4) formed thereon, wherein the first layer (1) is silicon;
first (2) and second (3) sealing layers, wherein the first layer is sandwiched between the first and second sealing layers and anodically bonded thereto to define a cavity (5) therein;
a gas provided within the cavity; and
an electrode (6), **characterized in that** the electrode is formed on at least a part of a surface of the second sealing layer internal to the cavity and arranged to be in electrical contact with the first layer, for fixing the electrode potential at the silicon potential during anodic bonding such that the electrode reduces UV emission.

2. A device according to claim 1, wherein the first (2) and second (3) sealing layers are glass.

3. A device according to any preceding claim, wherein the distance between the micro-mechanical component (4) and the electrode (6) is not less than about 100 µm at any point on the electrode (6).

4. A device according to any preceding claim, wherein the electrode (6) comprises at least one electrical contact structure (7) arranged to contact at least one anodically bonded part of the surface of the second sealing layer (3) internal to the cavity (5), the at least one electrical contact structure arranged to be the only part of the electrode that makes such contact.

5. A device according to any of claims 1 to 3, wherein the electrode (6) is formed on the entire surface of the second sealing layer (3) internal to the cavity (5).

6. A method for manufacturing a multi-layer device, the method comprising the steps of:
providing a first layer (1) with a micro-mechanical component (4) formed thereon, wherein the first layer (1) is silicon;
anodically bonding a first sealing layer (2) to the first layer in vacuum, and
anodically bonding a second sealing layer (3) to the first layer in the presence of a gas to define a cavity (5) provided with the gas therewithin;
**characterized in that** an electrode (6) is formed on at least a part of a surface of the second sealing layer internal to the cavity and arranged to be in contact with the first layer during bonding of the second sealing layer to the first layer for fixing the electrode potential at the silicon potential during anodic bonding such that the electrode reduces UV emission.

7. A method according to claim 6, wherein the first (2) and second (3) sealing layers are glass.

8. A method according to any of claims 6 or 7, wherein the step of bonding the second sealing layer (3) to the first layer (1) is performed such that the resulting distance between the micro-mechanical component (4) and the electrode (6) is not less than about 100 µm at any point on the electrode.

9. A device according to any of claims 6 to 8, wherein the electrode (6) is only in contact with the first layer (1) during bonding by means of at least one electrical contact structure (7).

10. A method according to any of claims 6 to 9, wherein the electrode (6) is formed on the entire surface of the second sealing layer (3) internal to the cavity.

## Patentansprüche

1. Mehrschichtvorrichtung, die Folgendes umfasst:
eine erste Schicht (1) mit einer mikromechanischen Komponente (4), die darauf gebildet ist, wobei die erste Schicht (1) Silicium ist;
eine erste (2) und zweite (3) Versiegelungsschicht, wobei die erste Schicht zwischen der ersten und der zweiten Versiegelungsschicht eingezwängt ist und anodisch an diese gebondet ist, so dass ein Hohlraum (5) darin definiert ist;
ein Gas, das innerhalb des Hohlraums bereitgestellt ist; und
eine Elektrode (6), **dadurch gekennzeichnet, dass** die Elektrode auf wenigstens einem Teil einer Oberfläche der zweiten Versiegelungsschicht innerhalb des Hohlraums gebildet ist und so angeordnet ist, dass sie sich in elektrischem Kontakt mit der ersten Schicht befindet, um das Elektrodenpotential während eines anodischen Bondens auf dem Siliciumpotential zu fixieren, so dass die Elektrode UV-Emissionen reduziert.

2. Vorrichtung nach Anspruch 1, wobei die erste (2) und die zweite (3) Versiegelungsschicht Glas sind.

3. Vorrichtung nach einem vorhergehenden Anspruch, wobei der Abstand zwischen der mikromechanischen Komponente (4) und der Elektrode (6) an keinem Punkt der Elektrode (6) weniger als etwa 100 µm beträgt.

4. Vorrichtung nach einem Vorhergehenden Anspruch, wobei die Elektrode (6) wenigstens eine elektrische Kontaktstruktur (7) umfasst, die so angeordnet ist, dass sie wenigstens einen anodisch gebondeten Teil der Oberfläche der zweiten Versiegelungsschicht (3) innerhalb des Hohlraums (5) kontaktiert, wobei die wenigstens eine elektrische Kontaktstruktur so angeordnet ist, dass sie der einzige Teil der Elektrode ist, der einen solchen Kontakt herstellt.

5. Vorrichtung nach einem der Ansprüche 1 bis 3, wobei die Elektrode (6) auf der gesamten Oberfläche der zweiten Versiegelungsschicht (3) innerhalb des Hohlraums (5) gebildet ist.

6. Verfahren zur Herstellung einer Mehrschichtvorrichtung, wobei das Verfahren die folgenden Schritte umfasst:
Bereitstellen einer ersten Schicht (1) mit einer mikromechanischen Komponente (4), die darauf gebildet ist, wobei die erste Schicht (1) Silicium ist;
anodisches Bonden einer ersten Versiegelungsschicht (2) an die erste Schicht in Vakuum, und
anodisches Bonden einer zweiten Versiegelungsschicht (3) an die erste Schicht in der Anwesenheit eines Gases, so dass ein Hohlraum (5) mit dem darin bereitgestellten Gas definiert wird;
**dadurch gekennzeichnet, dass** eine Elektrode (6) auf wenigstens einem Teil einer Oberfläche der zweiten Versiegelungsschicht innerhalb des Hohlraums gebildet wird und so angeordnet wird, dass sie sich während des Bondens der zweiten Versiegelungsschicht an die erste Schicht in Kontakt mit der ersten Schicht befindet, um das Elektrodenpotential während des anodischen Bondens auf dem Siliciumpotential zu fixieren, so dass die Elektrode UV-Emissionen reduziert.

7. Verfahren nach Anspruch 6, wobei die erste (2) und die zweite (3) Versiegelungsschicht Glas sind.

8. Verfahren nach einem der Ansprüche 6 und 7, wobei der Schritt des Bondens der zweiten Versiegelungsschicht (3) an die erste Schicht (1) so durchgeführt wird, dass der resultierende Abstand zwischen der mikromechanischen Komponente (4) und der Elektrode (6) an keinem Punkt der Elektrode weniger als etwa 100 µm beträgt.

9. Vorrichtung nach einem der Ansprüche 6 bis 8, wobei sich die Elektrode (6) während des Bondens nur mittels wenigstens einer elektrischen Kontaktstruktur (7) in Kontakt mit der ersten Schicht (1) befindet.

10. Verfahren nach einem der Ansprüche 6 bis 9, wobei die Elektrode (6) auf der gesamten Oberfläche der zweiten Versiegelungsschicht (3) innerhalb des Hohlraums gebildet wird.

## Revendications

1. Dispositif multicouches comprenant :
une première couche (1) sur laquelle est formé un composant (4) micromécanique, la première couche (1) étant du silicium ;
des première (2) et deuxième (3) couches de scellement, la première couche étant prise en sandwich entre la première et la deuxième couches de scellement et y étant liée anodiquement pour y définir une cavité (5) ;
un gaz dans la cavité et
une électrode (6), **caractérisée en ce que** l'électrode est formée sur au moins une partie d'une surface de la deuxième couche de scellement, d'une manière interne à la cavité, et est disposée de manière à être en contact électrique avec la première couche pour fixer le potentiel de l'électrode au potentiel du silicium pendant une liaison anodique, de façon à ce que l'électrode réduise une émission d'UV.

2. Dispositif suivant la revendication 1, dans lequel la première (2) et la deuxième (3) couches de scellement sont du verre.

3. Dispositif suivant l'une quelconque des revendications précédentes, dans lequel la distance entre le composant (4) micromécanique et l'électrode (6) n'est pas plus petite qu'environ 100 µm en tout point de l'électrode (6).

4. Dispositif suivant l'une quelconque des revendications précédentes, dans lequel l'électrode (6) comprend au moins une structure (7) de contact électrique disposée de manière à contacter au moins une partie liée anodiquement de la surface de la deuxième couche (3) de scellement, d'une manière interne à la cavité (5), la au moins une structure de contact électrique étant disposée de manière à être la seule partie de l'électrode, qui fait un contact de ce genre.

5. Dispositif suivant l'une quelconque des revendications 1 à 3, dans lequel l'électrode (6) est formée sur toute la surface de la deuxième couche (3) de scellement, d'une manière interne à la cavité (5).

6. Procédé de fabrication d'un dispositif multicouches, le procédé comprenant les stades dans lesquels :
on se procure une première couche (1) sur laquelle est formé un composant (4) micromécanique, la première couche (1) étant du silicium ;
on effectue une liaison anodique d'une première couche (2) de scellement à la première couche sous vide et
on effectue une liaison anodique d'une deuxième couche (3) de scellement à la première couche en la présence d'un gaz pour définir une cavité (5) contenant le gaz ;
**caractérisé en ce qu'**on forme une électrode (6) sur au moins une partie d'une surface de la deuxième couche de scellement d'une manière interne à la cavité et on la dispose pour qu'elle soit en contact avec la première couche pendant la liaison de la deuxième couche de scellement à la première couche, pour fixer le potentiel de l'électrode au potentiel du silicium pendant une liaison anodique, de façon à ce que l'électrode réduise une émission d'UV.

7. Procédé suivant la revendication 6, dans lequel la première (2) et la deuxième (3) couches de scellement sont du verre.

8. Procédé suivant l'une quelconque des revendications 6 ou 7, dans lequel on effectue le stade de liaison de la deuxième couche (3) de scellement à la première couche (1), de manière à ce que la distance résultante entre le composant (4) micromécanique et l'électrode (6) ne soit pas plus petite qu'environ 100 µm en tout point de l'électrode.

9. Procédé suivant l'une quelconque des revendications 6 à 8, dans lequel l'électrode (6) est seulement en contact avec la première couche (1) pendant la liaison au moyen d'au moins une structure (7) de contact électrique.

10. Procédé suivant l'une quelconque des revendications 6 à 9, dans lequel on forme l'électrode (6) sur toute la surface de la deuxième couche (3) de scellement, d'une manière interne à la cavité.
